# FASCICULE DE BREVET EUROPEEN

(11) **EP 2 691 253 B1**
(45) Date de publication et mention de la délivrance du brevet: **07.12.2016**
(21) Numéro de dépôt: 12717794.7
(22) Date de dépôt: 25.03.2012
(51) Int. Cl.: B60K 37/06, G06F 3/044

(54) **MODULE DE COMMANDE ET D'AFFICHAGE POUR VEHICULE AUTOMOBILE**
STEUERUNGS- UND ANZEIGEMODUL FÜR KRAFTFAHRZEUGE
CONTROL AND DISPLAY MODULE FOR MOTOR VEHICLES

(30) Priorité: 31.03.2011 FR 1100973
(43) Date de publication de la demande: 05.02.2014
(73) Titulaire: Valeo Systemes Thermiques, 78320 Le Mesnil Saint Denis (FR)
(72) Inventeur: BERAUD, Henry, F-94300 Vincennes (FR)
(74) Mandataire: Pothmann, Karsten
(86) Numéro de dépôt international: PCT/FR2012/000116
(87) Numéro de publication internationale: WO 2012/131192

(56) Documents cités:
- WO-A1-2011/010009

## Description

La présente invention concerne le domaine des modules de commande et d'affichage à surface tactile pour véhicule automobile. Plus particulièrement, un tel module trouve une application avantageuse pour les commandes situées à proximité du conducteur, au niveau du panneau de bord ou de la console avant d'un véhicule automobile pour, par exemple, commander des fonctions de climatisation, d'un système audio, d'un système de téléphonie, d'un système multimédia ou encore d'un système de navigation.

Le document WO 2011/010009A1 divulgue un module de commande et d'affichage selon le préambule de la revendication 1.

Les dispositifs de commande et d'affichage de véhicule automobile comportent un écran d'affichage pour l'affichage de données d'information ou de commande. Ces écrans peuvent être recouverts par exemple d'une dalle tactile transparente permettant la saisie de commandes par les utilisateurs du véhicule. Certains dispositifs comportent en outre des boutons de commande supplémentaires disposés à proximité de l'écran.

La dalle tactile permet de déterminer les coordonnées de l'appui d'un doigt d'utilisateur en utilisant par exemple les technologies résistive ou capacitive.

Selon un exemple de technologie, la dalle tactile résistive comporte un sandwich d'une couche déformable (tel qu'un film de plastique ou une feuille de verre semi-souple) métallisée en vis-à-vis d'un substrat de verre métallisé, la couche déformable et le substrat étant séparés par des entretoises isolantes. Quand l'utilisateur appuie sur la dalle tactile, il déforme la couche qui s'affaisse sur le substrat de verre créant un contact électrique. Une tension représentant analogiquement la position touchée est alors produite.

Ces dalles tactiles peuvent par exemple être des films utilisant une technologie dite ITO dans laquelle deux couches dont les surfaces opposées présentent chacune un revêtement conducteur résistif transparent en oxyde d'indium étain (ITO).

Dans le cas des dalles tactiles capacitives, c'est l'approche plus ou moins soutenue du doigt ou d'un stylet qui provoque une perturbation repérable du champ capacitif et permet de définir la position du doigt ou stylet sur la dalle.

D'autre part, les dalles tactiles sont des éléments minces et fragiles. Il est donc nécessaire de les protéger notamment vis-à-vis des chocs qui pourraient être engendrés par les utilisateurs.

De plus, les constructeurs automobiles cherchent aujourd'hui à rendre les façades de véhicule plus ergonomiques pour l'utilisateur en proposant des modules de commande d'aspect lisse et uniforme au toucher.

Par ailleurs, afin d'obtenir une bonne qualité d'affichage, les constructeurs automobiles sont confrontés à différentes contraintes comme la réduction de la distance entre l'écran d'affichage et la surface tactile ou l'étanchéité entre l'écran d'affichage et la dalle tactile, notamment vis-à-vis de la poussière et de l'humidité.

L'invention propose donc un module de commande et d'affichage amélioré pour véhicule automobile permettant d'obtenir une façade d'aspect lisse et uniforme au toucher et permettant d'obtenir une bonne qualité d'affichage.

Les modes de réalisation de la présente invention ont donc pour objet un module de commande et d'affichage pour véhicule automobile comportant:
- un écran d'affichage pour l'affichage de données,
- une dalle tactile destinée à la saisie de commandes par un utilisateur, ladite dalle tactile superposant au moins partiellement ledit écran d'affichage,
- un boîtier dans lequel sont logés ledit écran d'affichage et ladite dalle tactile, ledit boîtier comportant un cadre frontal,
   caractérisé en ce que:
   - le boîtier présente un rebord interne saillant entre l'écran d'affichage et la dalle tactile, ledit rebord interne maintenant en position l'écran d'affichage dans le boîtier et en ce que,
   - le module de commande et d'affichage comporte également un joint dont une première partie est intercalée entre le rebord interne du boîtier et l'écran d'affichage et une deuxième partie dépasse du rebord interne vers le centre de l'écran d'affichage.

Selon un autre aspect de la présente invention, la deuxième partie du joint dépassant du rebord interne relie de manière étanche l'écran d'affichage et la dalle tactile.

Selon un autre mode de réalisation de la présente invention, le module de commande et d'affichage comporte un joint supplémentaire dont une première partie est intercalée entre la dalle tactile et le rebord interne du boîtier et une deuxième partie dépasse du rebord interne vers le centre de l'écran d'affichage, les deuxièmes parties du joint et du joint supplémentaire coopérant pour relier de manière étanche l'écran d'affichage et la dalle tactile.

Selon un aspect supplémentaire de la présente invention, le joint et/ou le joint supplémentaire comprend un matériau souple à cellule fermées.

Selon un aspect additionnel de la présente invention, le joint et/ou le joint supplémentaire comprend un matériau souple à cellules ouvertes.

Selon un autre aspect de la présente invention, le joint et/ou le joint supplémentaire comprend une mousse de polyéthylène.

Selon un aspect supplémentaire de la présente invention, le joint et/ou le joint supplémentaire comporte un élastomère de type éthylène-propylène-diène monomère (EPDM).

Selon un aspect supplémentaire de la présente invention, le joint et/ou le joint supplémentaire est bi-adhésif.

Selon un autre aspect de la présente invention, la longueur de la première partie et la deuxième partie du joint est comprise entre 2 et 5 millimètres.

Selon un aspect additionnel de la présente invention, la première partie du joint et/ou du joint supplémentaire est comprimée d'au moins 50% de son épaisseur initiale sans contrainte.

Selon un autre mode de réalisation de la présente invention, le joint et/ou le joint supplémentaire est bi-étagé de sorte que la première et la deuxième partie du joint et/ou du joint supplémentaire présentent des épaisseurs différentes.

Selon un autre aspect de la présente invention, ledit module comprend également un film de protection fixé sur les bords externes du cadre frontal du boîtier et à l'arrière duquel est fixée la dalle tactile.

Selon un aspect supplémentaire de la présente invention, la fixation entre le film de protection et la dalle tactile est réalisée par collage.

Selon un aspect additionnel de la présente invention, le film de protection comporte une teinte opaque locale pour masquer au moins le rebord interne du boîtier à l'utilisateur.

Selon un autre aspect de la présente invention, la dalle tactile est une dalle capacitive.

Selon un aspect supplémentaire de la présente invention, le rebord interne du boîtier est formé par un insert métallique fixé au boîtier.

D'autres caractéristiques et avantages de l'invention apparaîtront dans la description qui va maintenant en être faite, en référence aux dessins annexés qui en représentent, à titre indicatif mais non limitatif, un mode de réalisation possible.

Sur ces dessins:
- la figure 1 représente un schéma d'une vue de face du module de commande et d'affichage selon un mode de réalisation de la présente invention;
- la figure 2 représente un schéma d'une vue en coupe transversale d'un module de commande et d'affichage selon un premier mode de réalisation de la présente invention selon une ligne de coupe I-I;
- la figure 3 représente un schéma d'une vue en coupe transversale d'un module de commande et d'affichage selon un deuxième mode de réalisation de la présente invention selon une ligne de coupe I-I;
- la figure 4 représente un schéma d'une vue en coupe transversale d'un module de commande et d'affichage selon un troisième mode de réalisation de la présente invention selon une ligne de coupe I-I;
- la figure 5 représente un schéma d'un détail II de la figure 2 selon un premier mode de réalisation de la présente invention ainsi que les angles de vision extrêmes des utilisateurs;
- les figures 6a à 6d représentent des schémas des différentes étapes d'assemblage des éléments d'un premier mode de réalisation d'un module de commande et d'affichage selon la présente invention;
- la figure 7a et 7b représente des vues schématiques de face du module de commande et d'affichage selon un mode de réalisation alternatif de la présente invention;

Sur ces dessins les mêmes numéros de référence représente les mêmes éléments.

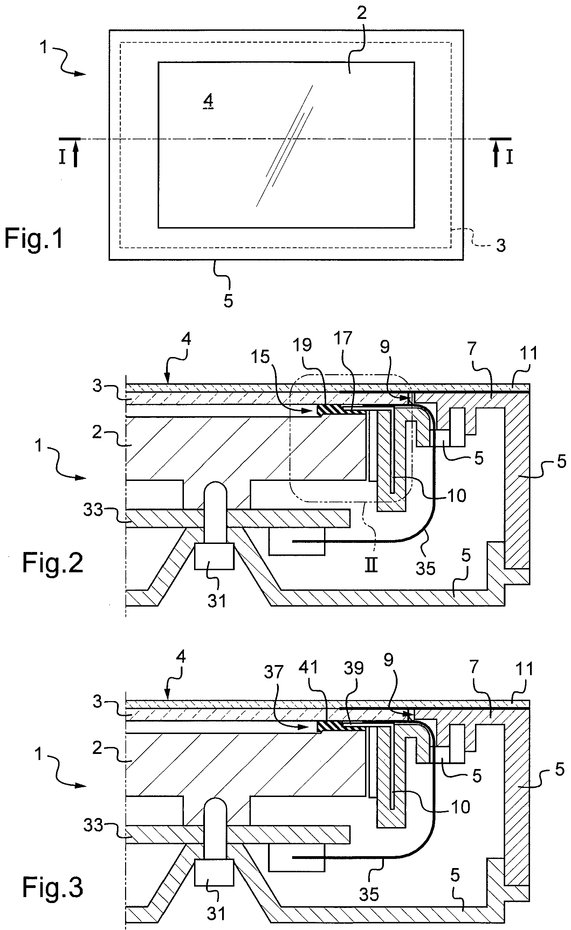

La figure 1 représente une vue schématique de face d'un module de commande et d'affichage 1 pour véhicule automobile, le module étant disposé sensiblement à la verticale dans le véhicule. Le module de commande et d'affichage 1 peut être fixé à proximité de l'utilisateur, par exemple au niveau de la console centrale du véhicule ou au niveau du panneau de bord (non représenté) pour par exemple commander des fonctions de climatisation, d'un système audio, d'un système de téléphonie, d'un système multimédia ou encore d'un système de navigation.
Sur cette figure, le module de commande et d'affichage 1 comporte un écran d'affichage 2, pour l'affichage de données d'information ou de commande, au moins une dalle tactile 3 (représentée en pointillés) et présente une surface frontale de commande 4 pour la saisie de commandes par un utilisateur, la surface frontale de commande 4 étant au moins superposée à l'écran d'affichage 2, et un boîtier 5 dans lequel sont logés l'écran d'affichage 2 et la dalle tactile 3. Dans le premier exemple représenté sur la figure 1, la dalle tactile 3 recouvre l'écran d'affichage 2 en dépassant sur les côtés de l'écran 2.

La dalle tactile 3 est transparente pour être placée devant l'écran d'affichage 2 et pour servir de moyen de saisie. La dalle tactile 3 détermine les coordonnées du point où l'utilisateur appuie avec son doigt sur la surface frontale de commande 4, dans le plan de la dalle 3. La dalle tactile 3 comporte, par exemple, des propriétés résistives ou capacitives. Le déplacement ou l'appui du doigt d'un utilisateur provoque la création d'un signal variant avec la localisation et le déplacement de son doigt au contact et selon l'étendue sur cette surface.

Selon un mode de réalisation, la dalle tactile 3 utilisent la technologie ITO pour "Indium Tin Oxide" en anglais. Plus précisément, une telle dalle comprend deux couches dont les surfaces opposées présentent chacune un revêtement conducteur résistif transparent en oxyde d'indium étain (ITO). Ces surfaces sont distancées l'une de l'autre par des séparateurs à l'état de repos.

Lorsque la surface frontale de commande 4 liée à la dalle tactile est touchée, un contact électrique est établi entre les deux surfaces opposées et produit une tension. Le niveau de tension détecté est représentatif des coordonnées de l'appui sur la surface frontale de commande 4.

Par ailleurs, L'écran d'affichage 2 est par exemple un écran TFT (utilisant la technologie de couches minces de transistor ou « Thin Film Transistor » en anglais), par exemple un écran 7 pouces (ou 17, 78 cm).

L'écran d'affichage 2 et la dalle tactile 3 permettent ainsi la saisie de commandes et l'affichage de données correspondantes.

La figure 2 représente une vue en coupe de dessus d'une partie du module de commande et d'affichage 1 permettant de mieux distinguer la position des différents éléments. Ainsi, le module de commande et d'affichage 1 comprend un boîtier 5 comportant un cadre frontal 7 présentant une ouverture 9 et un rebord interne 10. Le boîtier 5 est, par exemple, en plastique ou en élastomère rigide.

L'écran d'affichage 2 est positionné à l'intérieur du boîtier 5 et orienté vers la surface frontale de commande 4. La dalle tactile 3 est positionnée au niveau de l'ouverture 9 du cadre frontal 7 et superpose au moins partiellement l'écran d'affichage 2. La dalle tactile 3 est fixée derrière un film de protection 11 dont la surface externe constitue la surface frontale de commande 4.

La fixation de la dalle tactile 3 sur le film de protection 11 est réalisée par collage en utilisant une « colle optique » qui permet de garantir une bonne qualité de transparence. Le film de protection 11 est lui fixé sur la surface externe du cadre frontale 7. La fixation est réalisée en collant le film de protection 11 de manière à ce qu'il soit « tendu » sur le cadre frontal 7.

Le film de protection 11 est, par exemple, un film semi-rigide fin en polycarbonate qui peut être laminé, décoré par sérigraphie et maintenu sur le cadre frontal 7 par collage ou par surmoulage. De plus, ce film de protection 11 peut être recouvert d'un film polariseur de manière à limiter les effets de brillance ainsi que les empreintes de traces de doigts. Un vernis anti-rayures peut également être apposé sur la surface extérieure du film de protection.

Par ailleurs, l'écran d'affichage 2 est, d'une part, fixé au boîtier 5 par l'arrière, par exemple, par des vis de fixation 31 situées à l'arrière du boîtier 5, c'est-à-dire au côté opposé à la surface frontale de commande 4 et, d'autre part, maintenu par l'avant au niveau de la périphérie de l'écran d'affichage 2 par le rebord interne 10 faisant saillie entre l'écran d'affichage 2 et la dalle tactile 3.

Afin de limiter son épaisseur, le rebord interne 10 du boîtier 5 est formé par un insert métallique fixé au boîtier 5, par exemple un insert en inox ou en acier qui peut être fixé par surmoulage, collage, bouterolage, rivetage, vissage ou clipsage au boîtier 5. Le boîtier 5 est, par exemple, surmoulé sur l'insert métallique 10.

De plus, afin d'assurer l'étanchéité, notamment vis-à-vis des poussières ou de l'humidité qui pourraient s'infiltrer entre l'écran d'affichage 2 et la dalle tactile 3, le module de commande et d'affichage 1 comprend également au moins un joint.

Selon un premier mode de réalisation représenté sur la figure 2, le module de commande et d'affichage 1 comporte un joint uniforme 15. Une première partie 17 du joint 15 est intercalée entre le rebord interne 10 formé par l'insert métallique et l'écran d'affichage 2 ce qui permet de maintenir l'écran d'affichage 2 en position tout en le protégeant d'un contact avec l'insert métallique 10 et une deuxième partie 19 du joint 15 dépasse du rebord interne vers le centre de l'écran d'affichage 2. Dans ce cas, le joint 15 est une mousse ouverte fortement compressible de sorte que la première partie 17 du joint 15 est comprimée de manière à réduire son épaisseur d'au moins 50% par rapport à son épaisseur initiale sans contrainte, de sorte que la deuxième partie 19 assure l'étanchéité entre l'écran d'affichage 2 et la dalle tactile 3. La première partie est, par exemple comprimée de 70% et la deuxième partie comprimée de 20%. Cette forte compression permet d'obtenir une deuxième partie 19 du joint 15 dont l'épaisseur est supérieure à l'épaisseur formée par la première partie 17 et le rebord interne 10 réunis et permet ainsi de combler l'interstice situé entre le rebord interne 10 et la dalle tactile de manière à assurer l'étanchéité entre l'écran d'affichage 2 et la dalle tactile 3.

Ce type de joints 15 peut être fabriqué à partir d'élastomère en mousse à cellules de type éthylène-propylène-diène monomère (EPDM) tel qu'un polyéthylène. En effet, ces matériaux présentent l'avantage d'avoir un prix de revient faible et d'être ininflammable ce qui est requis dans le domaine automobile.

De plus, le joint 15 permet de rattraper les éventuels écarts de tolérance concernant les épaisseurs des différents éléments du module de commande et d'affichage 1 et de protéger l'écran d'affichage 2 vis-à-vis des vibrations ou des chocs. Il est également à noter que de fortes variations de température peuvent survenir au niveau du module de commande et d'affichage 1 notamment à cause des sources d'éclairage présentes ce qui peut induire une dilatation des différents éléments du module de commande et d'affichage 1, le joint 15 permettant de maintenir les éléments en place et de limiter les contraintes notamment au niveau de l'écran d'affichage 2 et de la dalle tactile 3 qui sont des éléments relativement fragiles.

L'écran d'affichage 2 est donc maintenu d'une part par les vis de fixation 31 et d'autre part par le rebord interne 10 matérialisé par l'insert métallique par l'intermédiaire de la première partie 17 du joint 15. Cette première partie 17 du joint 15 peut, par exemple, avoir une longueur de 2 à 5 mm. La deuxième partie 19 du joint 15 ayant une longueur similaire de 2 à 5 mm. De plus, le joint 15 peut avoir un épaisseur initiale de 0,8mm, l'épaisseur étant réduite à 0,3mm après compression au niveau de la première partie 17. L'épaisseur de l'insert métallique 10 peut, par exemple, être de 0,3mm également. La deuxième partie 19 du joint 15 permet de joindre l'écran d'affichage 2 et la dalle tactile 3 et permet également de protéger la dalle tactile 3 d'un éventuel contact avec l'insert métallique 10. Cependant, la compression de la deuxième partie 19 du joint 15 doit être limitée de manière à limiter la pression exercé par le joint 15 sur la dalle tactile 3, ce qui pourrait conduire à une déformation de la dalle et de l'écran de protection 11 sur lequel la dalle est fixée, déformation qui pourrait être sensible à la vue et au toucher par l'utilisateur.

L'épaisseur de la dalle tactile 3 est d'environ 1,1 mm et l'épaisseur du film de protection 11 est d'environ 0,75 mm ainsi la distance totale entre l'écran d'affichage 2 et la surface frontale de commande 4 est d'environ 3mm (0,75+1,1+0,8+0,3), l'écran d'affichage 2 présentant un rebord de 0,3mm à sa périphérie.

D'autre part, le module de commande et d'affichage 1 comprend un circuit imprimé 33 connecté d'une part à l'écran d'affichage 2 et d'autre part à la dalle tactile 3 par l'intermédiaire d'une nappe de connexion 35 et permettant de gérer les signaux électroniques de commande et d'affichage.

La liaison entre la nappe de connexion 35 et la dalle tactile 3 peut se trouver sur l'une ou l'autre des faces de la dalle tactile 3 suivant la technologie utilisée de sorte que lorsque la liaison est réalisée sur la face en contact avec l'écran de protection 11, la sur-épaisseur créée par la liaison entre la nappe de connexion 35 et la dalle tactile 3 doit être compensée, par exemple par une nappe de colle ou un film transparent pour éviter une différence de niveau sensible au toucher par l'utilisateur.

Selon un deuxième mode de réalisation représenté sur la figure 3, le joint est un joint bi-étagé 37 comprenant deux parties 39 et 41. La première partie 39 de faible épaisseur est destinée à être intercalée entre le rebord interne 10 formé par l'insert métallique et l'écran d'affichage 2. La deuxième partie 41 d'une épaisseur plus importante est destinée à dépasser du rebord interne 10 vers le centre de l'écran d'affichage 2 de manière à s'intercaler entre l'écran d'affichage 2 et la dalle tactile 3, les deux parties 39 et 41 du joint bi-étagé 37 ayant les même fonctions que les deux parties 17 et 19 du joint 15 dans le mode de réalisation précédent. Le joint bi-étagé 37 peut être formé d'une mousse ouverte ou d'une mousse fermée puisque dans ce mode réalisation, la première partie 39 du joint bi-étagé 37 n'est pas aussi comprimé que dans le mode de réalisation précédent. Ainsi, la première partie 39 du joint 37 peut, par exemple, avoir une longueur de 2 à 5 mm et une épaisseur initiale sans contrainte de 0,5 mm sans contrainte et 0,3 mm une fois comprimé tandis que la deuxième partie 41 peut avoir une une longueur de 2 à 5 mm et une épaisseur initiale sans contrainte de 0,9 ou 1 mm et de 0,8 mm environ une fois comprimée. La distance obtenue entre l'écran d'affichage 2 et la surface frontale de commande 4 pour ce mode de réalisation est la même que pour le mode de réalisation précédent. Les autres éléments du module de commande et d'affichage 1 de la figure 3 sont par ailleurs identiques au mode de réalisation précédent présenté sur la figure 2.

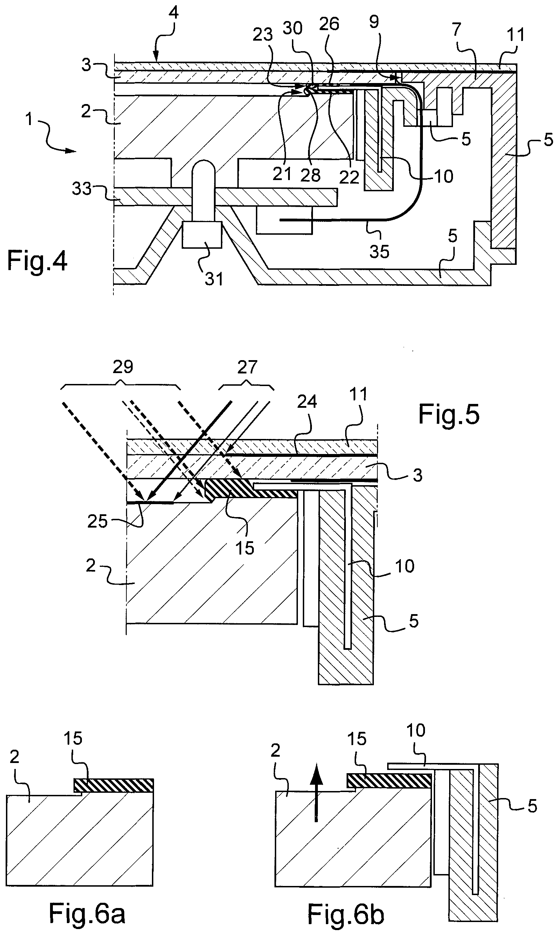

Selon un troisième mode de réalisation présenté sur la figure 4, en plus d'un joint 21 dont la première partie 22 est intercalée entre l'écran d'affichage 2 et le rebord interne 10 du boîtier 5, le module de commande et d'affichage 1 comprend un joint supplémentaire 23 dont la première partie 26 est intercalée entre le rebord interne 10 du boîtier 5 et la dalle tactile 3. les deuxièmes parties respectives 28 et 30 des deux joints 21 et 23 dépassant du rebord interne 10 vers le centre de l'écran d'affichage 2. La combinaison de deux joints 21 et 23 permet ainsi de créer une étanchéité entre l'écran d'affichage 2 et la dalle tactile 3. Dans ce cas, les deux joints 21 et 23 ont, par exemple, une épaisseur initiale sans contrainte de 0,5 ou 0,6 mm, la première partie des deux joints ayant une longueur de 2 à 5 mm et une épaisseur de 0,3 mm une fois comprimé et la deuxième partie ayant une longueur de 2 à 5 mm également. La distance obtenue entre l'écran d'affichage 2 et la surface frontale de commande 4 pour ce mode de réalisation est à peu près la même que pour les modes de réalisation précédents. Les autres éléments du module de commande et d'affichage 1 de la figure 4 sont par ailleurs identiques aux modes de réalisation précédents présentés sur les figures 2 et 3.

D'autre part, il est à noter que le ou les joints des modes de réalisation précédemment décrits permettent de masquer l'arête du rebord interne 10 constituée par l'insert métallique. En effet, le ou les joints peuvent être colorés, par exemple en noir mat, et ainsi masquer l'arête de l'insert métallique 10 qui n'a alors pas besoin d'être peint, ce qui réduit son coût.

De plus, dans les différents modes de réalisation présentés précédemment, le joint (respectivement les joints) peut être maintenu par la pression des éléments avec lesquels il est en contact mais le joint (respectivement les joints) peut aussi être un joint bi-adhésif, c'est-à-dire, que ses deux faces comportent une substance adhésive permettant d'assurer l'adhésion du joint (respectivement des joints) avec les surfaces des éléments avec lesquels il est en contact. Selon un mode de réalisation alternatif, le joint peut comprendre une substance adhésive sur l'une seulement de ses faces, ce qui permet de maintenir le joint en place notamment pendant la fabrication, l'étanchéité étant assurée par la compression du joint.

D'autre part, les éléments techniques du module de commande et d'affichage 1 doivent être masqués du champ de vision de l'utilisateur afin d'obtenir une finition esthétique réussie. Pour cela, on applique une teinte opaque 24 (correspondant à un film décor) au niveau du film de protection 11 comme représenté sur la figure 5 schématisant un détail II de la figure 2. Cette teinte 24 est appliquée sur la face du film de protection 11 en contact avec la dalle tactile 3 et le cadre frontal 7 de manière à être insensible au toucher pour l'utilisateur et à faciliter l'application d'éventuels films polariseurs ou vernis anti-rayures sur la face externe du film de protection 11.

Ainsi, on a représenté sur la figure 5 par des flèches 27 et 29 les angles de vision d'un utilisateur considérés comme extrêmes et correspondant à un angle de 40° par rapport à la normale à l'écran d'affichage 2. La limite d'application pour la teinte opaque 24 est déterminée de manière à ce qu'elle ne masque pas le bord de l'image affichée (repérée par le trait 25) sur l'écran d'affichage 2 d'un côté (flèches 27) ce qui permet de masquer l'insert métallique de l'autre côté (flèches 29), l'arête de l'insert métallique 10 étant masquée par le joint 15. Ainsi l'utilisateur voit l'ensemble de l'image de l'écran d'affichage mais ne voit pas les parties techniques du module de commande et d'affichage 1 et notamment l'insert métallique 10. De plus, il est à noter qu'au lieu de la teinte opaque 24, un film polariseur ou fumé permet également de masquer l'aspect généralement grisâtre du joint et de l'éventuelle colle.

Afin de mieux comprendre la disposition des différents éléments du module de commande et d'affichage 1, les figures 6a-6d représentent différentes étapes de l'assemblage de certains éléments pour le premier mode de réalisation dans lequel le joint 15 a une épaisseur uniforme sur toute sa longueur.

La figure 6a représente la première étape du procédé de l'assemblage dans laquelle le joint 15, est positionné sur l'écran d'affichage 2 de manière à être aligné avec le rebord de l'écran d'affichage 2. Dans le cas d'un joint bi-adhésif, le joint 15 est collé sur l'écran d'affichage 2.

La figure 6b représente la deuxième étape du procédé de l'assemblage dans laquelle l'écran d'affichage 2 est positionné dans le boîtier 5 de manière à ce que la première partie 17 du joint 15 située sur le coté extérieur de l'écran d'affichage 2 vienne en appui contre le rebord interne 10. Dans le cas d'un joint bi-adhésif, le joint est collé au rebord interne 10.

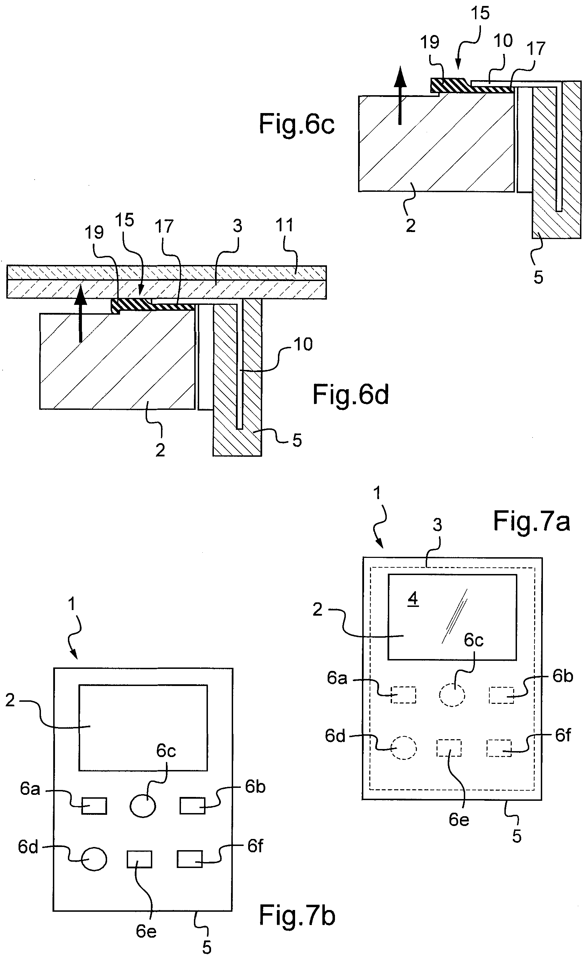

La figure 6c représente la troisième étape du procédé d'assemblage dans laquelle l'écran d'affichage 2 est ajusté en profondeur afin de comprimer la première partie 17 du joint 15 contre le rebord interne 10.

La figure 6d représente la quatrième étape du procédé d'assemblage dans laquelle l'ensemble comprenant la dalle tactile 3 et le film de protection 11 est fixé sur la surface externe du cadre frontal 7 du boîtier 5, ce qui entraîne une légère compression de la deuxième partie 19 du joint 15 par la dalle tactile 3. Dans le cadre d'un joint bi-adhésif, la deuxième partie 19 du joint 15 vient se coller à la dalle tactile 3. Ainsi, la deuxième partie 19 du joint 15 offre une étanchéité entre l'écran d'affichage 2 et la dalle tactile 3.

La figure 7a représente une vue schématique de face d'un mode de réalisation alternatif d'un module de commande et d'affichage 1 pour véhicule automobile dans lequel le module 1 comprend différentes zones de commande tactile (délimitées en pointillés). En plus de la zone tactile correspondant à l'écran d'affichage 2, le module 1 comprend également des zones tactiles 6a à 6f permettant de simuler des boutons de commande. Ces zones peuvent par exemple être rétro-éclairées pour être visualisés en conduite de jour ou de nuit et donner l'illusion que ceux-ci sont complètement intégrés dans le module 1.

De plus, ces zones de commande tactile 6a-6f ne sont pas pourvues d'écran d'affichage à l'arrière de la dalle tactile, ce qui permet de réduire sensiblement les coûts, tout en étant transparent pour l'utilisateur. Ainsi, en appliquant un teinte noire telle que la teinte opaque 24 présentée sur la figure 5 sur l'ensemble du film de protection sauf l'écran d'affichage 2 et les zones de commande rétro-éclairées 6a-6f, on obtient un surface frontale de commande lisse laissant apparaître l'image de l'écran d'affichage et les boutons rétro-éclairés comme représenté sur la figure 7b. De plus, dans une telle configuration, le boîtier 5 se prolonge vers les zones de commande tactile 6a-6f de manière à à produire un bloc rigide de soutien pour les équipements associés à ces zones de commande tactile 6a-6f.

Ainsi, les différents modes de réalisation de la présente invention permettent d'obtenir un maintien de l'écran d'affichage 2 en position même en cas de chocs ou de vibrations tout en garantissant une étanchéité entre l'écran d'affichage 2 et la dalle tactile 3. De plus, la distance entre la surface d'affichage de l'écran d'affichage 2 et la surface frontale de commande 4 est réduite ce qui assure une bonne qualité d'affichage pour l'utilisateur.

## Revendications

1. Module de commande et d'affichage (1) pour véhicule automobile comportant:
- un écran d'affichage (2) pour l'affichage de données,
- une dalle tactile (3) destinée à la saisie de commandes par un utilisateur, ladite dalle tactile (3) superposant au moins partiellement ledit écran d'affichage (2),
- un boîtier (5) dans lequel sont logés ledit écran d'affichage (2) et ladite dalle tactile (3), ledit boîtier (5) comportant un cadre frontal (7),
**caractérisé en ce que**:
- le boîtier (5) présente un rebord interne (10) saillant entre l'écran d'affichage (2) et la dalle tactile (3), ledit rebord interne (10) maintenant en position l'écran d'affichage (2) dans le boîtier (5) et **en ce que**,
- le module de commande et d'affichage (1) comporte également un joint (15, 21, 37) dont une première partie (17, 22, 39) est intercalée entre le rebord interne (10) du boîtier (5) et l'écran d'affichage (2) et une deuxième partie (19, 28, 41) dépasse du rebord interne (10) vers le centre de l'écran d'affichage (2).

2. Module de commande et d'affichage (1) selon la revendication 1 dans lequel la deuxième partie du joint (15, 37) dépassant du rebord interne (10) relie de manière étanche l'écran d'affichage (2) et la dalle tactile (3).

3. Module de commande et d'affichage (1) selon la revendication 1 comportant un joint supplémentaire (23) dont une première partie (26) est intercalée entre la dalle tactile (3) et le rebord interne (10) du boîtier (5) et une deuxième partie (30) dépasse du rebord interne (10) vers le centre de l'écran d'affichage (2), les deuxièmes parties (28, 30) du joint (21) et du joint supplémentaire (23) coopérant pour relier de manière étanche l'écran d'affichage (2) et la dalle tactile (3).

4. Module de commande et d'affichage (1) selon l'une des revendications précédentes dans lequel le joint (15, 21, 37) et/ou le joint supplémentaire (23) comprend un matériau souple à cellules fermées.

5. Module de commande et d'affichage (1) selon l'une quelconque des revendications 1 à 3 dans lequel le joint (15, 21, 37) et/ou le joint supplémentaire (23) comprend un matériau souple à cellules ouvertes.

6. Module de commande et d'affichage (1) selon l'une des revendications précédentes dans lequel le joint (15, 21, 37) et/ou le joint supplémentaire (23) comprend une mousse de polyéthylène.

7. Module de commande et d'affichage (1) selon l'une des 1 à 5 dans lequel le joint (15, 21, 37) et/ou le joint supplémentaire (23) comporte un élastomère de type éthylène-propylène-diène monomère (EPDM).

8. Module de commande et d'affichage (1) selon l'une des revendications précédentes dans lequel le joint (15, 21, 37) et/ou le joint supplémentaire (23) est bi-adhésif.

9. Module de commande et d'affichage (1) selon l'une des revendications précédentes dans lequel la longueur de la première partie (17, 22, 26, 39) et la deuxième partie (19, 28, 30, 41) du joint (15, 21, 37) et/ou du joint supplémentaire (23) est comprise entre 2 et 5 millimètres.

10. Module de commande et d'affichage (1) selon l'une des revendications précédentes dans lequel la première partie (17, 22, 26, 39) du joint (15, 21, 37) et/ou du joint supplémentaire (23) est comprimée d'au moins 50% de son épaisseur initiale sans contrainte.

11. Module de commande et d'affichage (1) selon l'une des revendications précédentes dans lequel le joint (15, 21, 37) et/ou le joint supplémentaire (23) est bi-étagé de sorte que la première (17, 22, 26, 39) et la deuxième partie (19, 28, 30, 41) du joint (15, 21, 37) et/ou du joint supplémentaire (23) présentent des épaisseurs différentes.

12. Module de commande et d'affichage (1) selon l'une des revendications précédentes dans lequel ledit module (1) comprend également un film de protection (11) fixé sur les bords externes du cadre frontal (7) du boîtier (5) et à l'arrière duquel est fixée la dalle tactile (3).

13. Module de commande et d'affichage (1) selon la revendication 12 dans lequel la fixation entre le film de protection (11) et la dalle tactile (3) est réalisée par collage.

14. Module de commande et d'affichage (1) selon la revendication 12 ou 13 dans lequel le film de protection (11) comporte une teinte opaque (24) locale pour masquer au moins le rebord interne (10) du boîtier (5) à l'utilisateur.

15. Module de commande et d'affichage (1) selon l'une des revendications précédentes dans lequel la dalle tactile (3) est une dalle capacitive.

16. Module de commande et d'affichage (1) selon l'une des revendications précédentes dans lequel le rebord interne (10) du boîtier (5) est formé par un insert métallique fixé au boîtier (5)

## Patentansprüche

1. Steuerungs- und Anzeigemodul (1) für Kraftfahrzeuge, umfassend:
- einen Anzeigebildschirm (2) zum Anzeigen von Daten,
- einen Touchscreen (3), der zum Eingeben von Befehlen durch einen Benutzer bestimmt ist, wobei der Touchscreen (3) den Anzeigebildschirm (2) mindestens teilweise überlagert,
- ein Gehäuse (5), in dem der Anzeigebildschirm (2) und der Touchscreen (3) angeordnet sind, wobei das Gehäuse (5) einen Frontrahmen (7) aufweist,
**dadurch gekennzeichnet, dass**:
- das Gehäuse (5) einen hervorstehenden Innenrand (10) zwischen dem Anzeigebildschirm (2) und dem Touchscreen (3) aufweist, wobei der Innenrand (10) den Anzeigebildschirm (2) in dem Gehäuse (5) in Position hält, und dass
- das Steuerungs- und Anzeigemodul (1) ebenfalls eine Dichtung (15, 21, 37) aufweist, wovon ein erster Teil (17, 22, 39) zwischen dem Innenrand (10) des Gehäuses (5) und dem Anzeigebildschirm (2) eingefügt ist, und ein zweiter Teil (19, 28, 41) von dem Innenrand (10) in Richtung der Mitte des Anzeigebildschirms (2) vorsteht.

2. Steuerungs- und Anzeigemodul (1) nach Anspruch 1, wobei der zweite Teil der Dichtung (15, 37), der von dem Innenrand (10) vorsteht, den Anzeigebildschirm (2) und den Touchscreen (3) dicht verbindet.

3. Steuerungs- und Anzeigemodul (1) nach Anspruch 1, umfassend eine zusätzliche Dichtung (23), wovon ein erster Teil (26) zwischen dem Touchscreen (3) und dem Innenrand (10) des Gehäuses (5) eingefügt ist und ein zweiter Teil (30) von dem Innenrand (10) in Richtung der Mitte des Anzeigebildschirms (2) vorsteht, wobei die zweiten Teile (28, 30) der Dichtung (21) und der zusätzlichen Dichtung (23) zusammenwirken, um den Anzeigebildschirm (2) und den Touchscreen (3) dicht zu verbinden.

4. Steuerungs- und Anzeigemodul (1) nach einem der vorhergehenden Ansprüche, wobei die Dichtung (15, 21, 37) und/oder die zusätzliche Dichtung (23) ein weiches, geschlossenzelliges Material aufweist.

5. Steuerungs- und Anzeigemodul (1) nach einem der Ansprüche 1 bis 3, wobei die Dichtung (15, 21, 37) und/oder die zusätzliche Dichtung (23) ein weiches, offenzelliges Material aufweist.

6. Steuerungs- und Anzeigemodul (1) nach einem der vorhergehenden Ansprüche, wobei die Dichtung (15, 21, 37) und/oder die zusätzliche Dichtung (23) einen Polyethylenschaum aufweist.

7. Steuerungs- und Anzeigemodul (1) nach einem der 1 bis 5, wobei die Dichtung (15, 21, 37) und/oder die zusätzliche Dichtung (23) ein Elastomer vom Typ des Ethylen-Propylen-Dien-Monomers (EPDM) aufweist.

8. Steuerungs- und Anzeigemodul (1) nach einem der vorhergehenden Ansprüche, wobei die Dichtung (15, 21, 37) und/oder die zusätzliche Dichtung (23) zweiseitig klebend ist.

9. Steuerungs- und Anzeigemodul (1) nach einem der vorhergehenden Ansprüche, wobei die Länge des ersten Teils (17, 22, 26, 39) und des zweiten Teils (19, 28, 30, 41) der Dichtung (15, 21, 37) und/oder der zusätzlichen Dichtung (23) zwischen 2 und 5 Millimetern liegt.

10. Steuerungs- und Anzeigemodul (1) nach einem der vorhergehenden Ansprüche, wobei der erste Teil (17, 22, 26, 39) der Dichtung (15, 21, 37) und/oder der zusätzlichen Dichtung (23) um mindestens 50 % seiner ursprünglichen Dicke ohne Beanspruchung komprimiert ist.

11. Steuerungs- und Anzeigemodul (1) nach einem der vorhergehenden Ansprüche, wobei die Dichtung (15, 21, 37) und/oder die zusätzliche Dichtung (23) derart zweistufig ist, dass der erste Teil (17, 22, 26, 39) und der zweite Teil (19, 28, 30, 41) der Dichtung (15, 21, 37) und/oder der zusätzlichen Dichtung (23) verschiedene Dicken aufweisen.

12. Steuerungs- und Anzeigemodul (1) nach einem der vorhergehenden Ansprüche, wobei das Modul (1) ebenfalls eine Schutzfolie (11) aufweist, die an den Außenrändern des Frontrahmens (7) des Gehäuses (5) befestigt ist und hinter der der Touchscreen (3) befestigt ist.

13. Steuerungs- und Anzeigemodul (1) nach Anspruch 12, wobei das Befestigen zwischen dem Schutzfilm (11) und dem Touchscreen (3) durch Kleben durchgeführt wird.

14. Steuerungs- und Anzeigemodul (1) nach Anspruch 12 oder 13, wobei der Schutzfilm (11) einen lokalen, opaken Farbton (24) aufweist, um mindestens den Innenrand (10) des Gehäuses (5) vor dem Benutzer zu verbergen.

15. Steuerungs- und Anzeigemodul (1) nach einem der vorhergehenden Ansprüche, wobei der Touchscreen (3) ein kapazitiver Touchscreen ist.

16. Steuerungs- und Anzeigemodul (1) nach einem der vorhergehenden Ansprüche, wobei der Innenrand (10) des Gehäuses (5) durch einen Metalleinsatz gebildet ist, der an dem Gehäuse (5) befestigt ist.

## Claims

1. Control and display module (1) for motor vehicles comprising:
- a display screen (2) for displaying data,
- a touchpad (3) intended for the input of commands by a user, said touchpad (3) at least partially overlaying said display screen (2),
- a casing (5) in which said display screen (2) and said touchpad (3) are housed, said casing (5) comprising a front frame (7),
**characterized in that**:
- the casing (5) has an internal rim (10) protruding between the display screen (2) and the touchpad (3), said internal rim (10) holding the display screen (2) in position in the casing (5), and **in that**,
- the control and display module (1) also comprises a seal (15, 21, 37) of which a first portion (17, 22, 39) is inserted between the internal rim (10) of the casing (5) and the display screen (2) and a second portion (19, 28, 41) extends beyond the internal rim (10) toward the center of the display screen (2).

2. Control and display module (1) according to Claim 1, in which the second portion of the seal (15, 37) extending beyond the internal rim (10) links the display screen (2) and the touchpad (3) in a seal-tight manner.

3. Control and display module (1) according to Claim 1, comprising an additional seal (23), of which a first portion (26) is inserted between the touchpad (3) and the internal rim (10) of the casing (5) and a second portion (30) extends beyond the internal rim (10) toward the center of the display screen (2), the second portions (28, 30) of the seal (21) and of the additional seal (23) cooperating to link the display screen (2) and the touchpad (3) in a seal-tight manner.

4. Control and display module (1) according to one of the preceding claims, in which the seal (15, 21, 37) and/or the additional seal (23) comprises a flexible material with closed cells.

5. Control and display module (1) according to any one of Claims 1 to 3, in which the seal (15, 21, 37) and/or the additional seal (23) comprises a flexible material with open cells.

6. Control and display module (1) according to one of the preceding claims, in which the seal (15, 21, 37) and/or the additional seal (23) comprises a polyethylene foam.

7. Control and display module (1) according to one of 1 to 5, in which the seal (15, 21, 37) and/or the additional seal (23) comprises an elastomer of ethylene-propylene-diene monomer (EPDM) type.

8. Control and display module (1) according to one of the preceding claims, in which the seal (15, 21, 37) and/or the additional seal (23) is bi-adhesive.

9. Control and display module (1) according to one of the preceding claims, in which the length of the first portion (17, 22, 26, 39) and the second portion (19, 28, 30, 41) of the seal (15, 21, 37) and/or of the additional seal (23) is between 2 and 5 millimeters.

10. Control and display module (1) according to one of the preceding claims, in which the first portion (17, 22, 26, 39) of the seal (15, 21, 37) and/or of the additional seal (23) is compressed by at least 50% of its initial thickness without stress.

11. Control and display module (1) according to one of the preceding claims, in which the seal (15, 21, 37) and/or the additional seal (23) is two-staged so that the first (17, 22, 26, 39) and the second (19, 28, 30, 41) portions of the seal (15, 21, 37) and/or of the additional seal (23) have different thicknesses.

12. Control and display module (1) according to one of the preceding claims, in which said module (1) also comprises a protective film (11) fixed to the outer edges of the front frame (7) of the casing (5) and behind which the touchpad (3) is fixed.

13. Control and display module (1) according to Claim 12, in which the fixing between the protective film (11) and the touchpad (3) is produced by gluing.

14. Control and display module (1) according to Claim 12 or 13, in which the protective film (11) comprises a local opaque tint (24) to mask at least the internal rim (10) of the casing (5) from the user.

15. Control and display module (1) according to one of the preceding claims, in which the touchpad (3) is a capacitive pad.

16. Control and display module (1) according to one of the preceding claims, in which the internal rim (10) of the casing (5) is formed by a metallic insert fixed to the casing (5).
